# EUROPÄISCHE PATENTSCHRIFT

(11) **EP 4 344 452 B1**
(45) Veröffentlichungstag und Bekanntmachung des Hinweises auf die Patenterteilung: **26.02.2025**
(21) Anmeldenummer: 22740792.1
(22) Anmeldetag: 24.06.2022
(51) Int. Cl.: H01H 33/666, H01H 47/32, H01H 3/28

(54) **ANORDNUNG UND VERFAHREN FÜR EINE AUTOMATISCHE KONFIGURATION EINES MAGNETANTRIEBS**
ARRANGEMENT AND METHOD FOR AUTOMATICALLY CONFIGURING A MAGNETIC DRIVE
ENSEMBLE ET PROCÉDÉ POUR LA CONFIGURATION AUTOMATIQUE D'UN ENTRAÎNEMENT MAGNÉTIQUE

(30) Priorität: 07.07.2021 DE 102021207110
(43) Veröffentlichungstag der Anmeldung: 03.04.2024
(73) Patentinhaber: Siemens Aktiengesellschaft, 80333 München (DE)
(72) Erfinder: BINDRICH, Martin, 13467 Berlin (DE); HINTZE, Thomas, 14612 Falkensee (DE); HIRTE, Malte Georg, 15370 Petershagen (DE); LECHELER, Stefan, 12277 Berlin (DE); SCHWOPE, Detlef, 12167 Berlin (DE); SCHÄFER, Mario, 14480 Potsdam (DE)
(74) Vertreter: Siemens Patent Attorneys
(86) Internationale Anmeldenummer: PCT/EP2022/067346
(87) Internationale Veröffentlichungsnummer: WO 2023/280597

(56) Entgegenhaltungen:
- DE-C1- 4 304 921
- FR-A1- 2 943 840
- US-B1- 7 483 254

## Beschreibung

Die Erfindung betrifft eine Anordnung für eine automatische Konfiguration eines Magnetantriebs gemäß dem Oberbegriff des Anspruchs 1 sowie ein Verfahren für eine automatische Konfiguration eines Magnetantriebs gemäß dem Oberbegriff des Anspruchs 8.

Aus der Betriebsanleitung "3TM Vakuum-Schütz 7,2 kV - 15 kV, 3-polig, 4,15 kV - 6,9 kV, 1-polig", Bestell-Nr.: 9229 0106 100 0, Siemens AG 2020, ist ein Schaltgerät für Mittelspannung bekannt, das eine Vakuumschalteinrichtung mit einem elektro-magnetischen Antrieb aufweist. Der Magnetantrieb kann dabei eine Magnetkraft auf eine sogenannte Ankerplatte ausüben und diese anziehen. Die Bewegung der Ankerplatte wird mechanisch in eine Bewegung zum Anpressen des beweglichen Kontakts an den Festkontakt innerhalb der Vakuumschalteinrichtung übersetzt. Bei diesem Gerät werden wie bei Magnetantrieben von Schaltern und Schützen häufig zwei Magnetspulen verwendet, die abhängig von der Höhe der Eingangsspannung entweder parallel (z. B. für AC/DC in Ländern mit 115 V Netzspannung) oder seriell (z. B. für AC/DC in Ländern mit 230 V Netzspannung) verschaltet werden müssen. Auch wenn die Netz-Nennspannung des Kunden bekannt ist, so ist in frühen Phasen einer Anlagenplanung oft noch nicht entschieden, welche Spannungsversorgung für den Schütz (Wechselspannung, Gleichspannung, Nennspannung) gewählt wird. Eine Auswahl der Spannungsversorgung wird durch den Kunden oft erst getroffen, wenn der Gesamtleistungsbedarf aller Anlagenkomponenten bekannt ist und auch die Steuerungsgeräte zur Ansteuerung der Schütze ausgewählt wurden.

Bei der Verschaltung der Spulen muss auf die richtige Polarität der Spulenanschlüsse geachtet werden. Auf der Ansteuerelektronik befinden sich wie auf Seiten 27 und 28 der Bedienungsanleitung gezeigt vier Steckkontakte X5, X6, X7, X8 mit je zwei Steckern, auf die die 2 x 2 Spulenanschlüsse gesteckt werden müssen. Es gibt also insgesamt 24 verschiedene Steckmöglichkeiten, von denen nur 12 (parallel oder seriell) richtig verschaltet sind. Das manuelle Verschalten, das im Werk für das jeweilige Auslieferungsland vorkonfiguriert wird, ist daher fehleranfällig.

Zusätzlich muss auch die Ansteuerelektronik entsprechend der Höhe der verwendeten Eingangsspannung konfiguriert werden. Dies geschieht entweder durch Steckbrücken oder Schalter auf der Elektronik oder bei Verwendung eines Mikrocontrollers durch entsprechende Parameterkonfiguration. Auch dieser Schritt wird im Werk vorkonfiguriert. Die Konfiguration der Ansteuerelektronik ist nötig, da je nach Spulenkonfiguration (parallel, seriell, Nennspannung) auf unterschiedliche Einschalt- und Halteströme geregelt werden muss.

Um es Kunden zu ermöglichen, das Schaltgerät nachträglich auf eine andere Spannung als ab Werk eingestellt umzukonfigurieren, sind die Anschlüsse hinter einer verschraubten Abdeckplatte zugänglich. Die Konfiguration des Schützes wird als Zeichnung und Text in allen benötigten Sprachen in kundentauglicher Form dem Produkt beigefügt, z.B. in Form eines Gerätehandbuchs oder einer separaten Montageanleitung. Die Beschreibungen sind daher sehr umfangreich. Ist die Beschreibung nicht vor Ort verfügbar, so ist eine korrekte Konfiguration schwierig bis unmöglich.

Ein weiteres Problem ist die Ersatzteillagerhaltung beim Kunden. Ein schneller Austausch eines defekten Schützes erfordert entweder die individuelle Konfiguration inklusive des Umsteckens der Spulenanschlüsse eines vorhandenen Reserveschützes oder die Bevorratung aller benötigten Varianten.

Ferner sind die Druckschriften US 7 483 254 B1, DE 43 04 921 C1 und FR 2 943 840 A1 bekannt.

Ausgehend von dem bekannten Schütz stellt sich an die Erfindung die Aufgabe, eine Anordnung anzugeben, mit der einfach, schnell und sicher eine Umrüstung des Magnetantriebs auf eine andere Eingangsspannung möglich ist.

Die Erfindung löst diese Aufgabe durch eine Anordnung für eine automatische Konfiguration eines Magnetantriebs gemäß Anspruch 1.

Um geringe Ausfallzeiten der Energieverteilungsanlage zu erreichen, ist ein möglichst einfacher Austausch ohne aufwendige und fehleranfällige Verschaltung der Spulen ein Mehrwert für den Kunden. Kurze Ausfallzeiten bei Störungen sind mittlerweile ein wirtschaftlich entscheidender Faktor bei der Auswahl eines Schützes, da im Bereich der Energieverteilung die Ausfallzeiten in den Strompreis einfließen. Es ist ein wesentlicher Vorteil der Erfindung, dass der manuelle Konfigurationsaufwand entfällt, was weniger fehleranfällig und schneller ist als bisher. Ferner werden trotz der etwas höheren Herstellungskosten (inkl. Stückprüfungskosten und Konfigurationskosten) einer erfindungsgemäßen Anordnung Einsparungen bei der Herstellung erzielt, weil ein manueller Konfigurationsaufwand und eine Überprüfung der korrekten Verdrahtung, ggf. sogar nach dem Vier-Augen-Prinzip, entfallen.

Der Vorteil einer automatischen Erkennung der Höhe der Eingangsspannung und die damit verbundene automatische Spulenverschaltung und Konfiguration der Ansteuerelektronik besteht darin, dass zum einen Fehler bei der manuellen Verschaltung und Konfiguration vermieden werden und zum anderen weniger Varianten gefertigt werden müssen.

Die Kundendokumentation kann bedeutend im Umfang reduziert werden und wird bei Ersatz eines Schützes nicht mehr vor Ort benötigt. Die Ersatzteilhaltung beim Kunden wird wesentlich vereinfacht, weil die Anzahl der Varianten in der Ersatzteilhaltung reduziert wird.

Der Begriff automatisch zielt im Sinne der Erfindung darauf ab, dass eine Konfiguration nicht mehr manuell durch einen Techniker erfolgen muss, sondern selbsttätig maschinell erfolgt. Bevorzugt kommt dabei eine im Schütz verbaute Elektronik zum Einsatz.

Ein Magnetantrieb ist eine bei z.B. Mittelspannungsanlagen übliche Bauweise für Schalteinrichtungen, bei der durch eine oder mehrere Spulen unter Spannung ein Magnetfeld erzeugt wird, das ein anderes ferromagnetisches Metallstück, z.B. eine Ankerplatte genannte Metallplatte, anzieht. Diese Anziehung bewirkt eine Bewegung, die auf einen beweglichen Kontakt in der Schalteinrichtung übertragen wird und diesen auf den Festkontakt presst. Typischerweise werden zwei Spulen eingesetzt, die parallel oder seriell schaltbar sind. Dies hat den Vorteil, dass die Magnetkraft annäherungsweise gleich gehalten werden kann, selbst wenn die Eingangsspannung wie eingangs erwähnt durch unterschiedliche Nennspannungen der Stromversorgung in unterschiedlichen Ländern für die Spulen unterschiedlich ausfällt. Die beiden Spulen des Magnetantriebs üben im eingeschalteten Zustand eine anziehende Kraft auf den Magnetanker aus. Die Übertragungsmechanik übersetzt die Bewegung des Magnetankers in eine Bewegung des beweglichen Kontakts zum Festkontakt hin und weist hierfür z.B. einen Kniehebel auf. Der Magnetantrieb weist steuerbare Schalteinrichtungen für die Spulen auf.

Eine Ansteuerungseinrichtung ist z.B. eine elektronische Schaltung oder ein Prozessor, der anhand einer gemessenen Eingangsspannung konfigurierbar ist, um den Magnetantrieb bzw. dessen Spulen zu steuern. Es werden Einschalt- und Halteströme für die Spulen geregelt.

Eine Vakuumschalteinrichtung im Sinne der Erfindung weist z.B. ein fluiddichtes Gehäuse auf, in dessen Inneren ein Vakuum herrscht (bzw. ein extrem niedriger Gasdruck unter 0,1 % Atmosphärendruck). Wird ein beweglicher Kontakt von einem Festkontakt z.B. mittels einer Federkraft schnell weggezogen, so wird ein entstehender Lichtbogen rasch gelöscht, u.a. weil kaum ionisierbares Medium für einen Stromfluss vorliegt. Vakuumschalteinrichtungen sind besonders gut zum Schalten von Wechselstrom geeignet, weil beim Nulldurchgang der Spannung ein Lichtbogen stets abreißt.

Die Konfigurationseinrichtung ist ein Kernaspekt der Erfindung. Sie weist z.B. eine Spannungsmesseinrichtung auf, um die Eingangsspannung zu messen. Ferner kann die Konfigurationseinrichtung die Ansteuerungseinrichtung auf die gemessene Eingangsspannung konfigurieren, d.h. der Ansteuerungseinrichtung die gemessene Eingangsspannung als digitalen oder analogen Wert mitteilen. Ferner kann die Konfigurationseinrichtung selbsttätig die steuerbaren Schalteinrichtungen ansteuern und auf diese Weise die Spulen in Abhängigkeit von der gemessenen Eingangsspannung parallel oder seriell verschalten. Die Konfigurationseinrichtung weist z.B. eine elektronische Schaltung oder einen Prozessor zur Datenverarbeitung auf.

In einer bevorzugten Ausführungsform der erfindungsgemäßen Anordnung ist die Konfigurationseinrichtung ausgebildet, die Spulen für eine gemessene Eingangsspannung von 90 V bis 150 V parallel zu schalten und für eine gemessene Eingangsspannung von 180 V bis 250 V seriell zu schalten. Dies ist ein Vorteil, weil die Magnetkraft der Spulen auf das vorgesehene Niveau geregelt wird.

In einer bevorzugten Ausführungsform der erfindungsgemäßen Anordnung ist die Konfigurationseinrichtung ausgebildet, die Spulen für eine gemessene Eingangsspannung von 20 V bis 29 V parallel zu schalten und für eine gemessene Eingangsspannung von 40 V bis 72 V seriell zu schalten. Dies ist ein Vorteil, weil die Magnetkraft der Spulen auf das vorgesehene Niveau geregelt wird.

In einer weiteren bevorzugten Ausführungsform der erfindungsgemäßen Anordnung ist die Konfigurationseinrichtung ausgebildet, als Eingangsspannung eine Wechselspannung zu messen.

In einer weiteren bevorzugten Ausführungsform der erfindungsgemäßen Anordnung ist die Konfigurationseinrichtung ausgebildet, als Eingangsspannung eine Gleichspannung zu messen.

In einer weiteren bevorzugten Ausführungsform der erfindungsgemäßen Anordnung ist die Konfigurationseinrichtung ausgebildet, die Ansteuerungseinrichtung auf die gemessene Eingangsspannung zu konfigurieren, indem Einschalt- und Halteströme festgelegt werden. Dies ist ein Vorteil, weil die Magnetkraft der Spulen auf das vorgesehene Niveau geregelt wird.

In einer weiteren bevorzugten Ausführungsform der erfindungsgemäßen Anordnung weisen die steuerbaren Schalteinrichtungen mindestens eine der folgenden Schalteinrichtungen auf: MOSFET, IGBT, Relais. Ein MOSFET ist ein Metall-Oxid-Halbleiter-Feldeffekttransistor und ein IGBT ist ein Bipolartransistor mit isolierter Gate-Elektrode. Ein Relais ist ein durch elektrischen Strom betriebener, fernbetätigter Schalter mit in der Regel zwei Schaltstellungen. Das Relais wird über einen Steuerstromkreis aktiviert und kann weitere Stromkreise schalten.

In einer weiteren bevorzugten Ausführungsform der erfindungsgemäßen Anordnung ist die Konfigurationseinrichtung ausgebildet, vor jedem Schaltvorgang die Eingangsspannung zu messen und die Ansteuerungseinrichtung zu konfigurieren und die Spulen zu verschalten. Die Detektion der Höhe der Eingangsspannung findet vor jedem Schaltvorgang statt. Dadurch ergibt sich z.B. eine Verzögerung der Einschaltung. Bei einer Wechselspannung als Eingangsspannung kann z.B. eine Halbwelle, also 10 ms bei 50 Hz und 8,3 ms bei 60 Hz, abgewartet werden, um die Eingangsspannung sicher zu detektieren. Bei einer Gleichspannung als Eingangsspannung ergibt sich keine Verzögerung. Findet die Detektion der Eingangsspannung über einen Analog-Digital Wandler statt, dann ergibt sich hier noch eine zusätzliche Verzögerungszeit durch die Wandlung und Auswertung in der Firmware. Bei dieser Verzögerungszeit handelt es sich aber um wenige µs bis maximal 1 ms, je nach Art des Wandlers. Sie ist deshalb vernachlässigbar. Eine zusätzliche Verzögerung, die im Bereich von einigen ms liegt, würde bei der Verwendung von Relais zur Spulenumschaltung entstehen. Diese Verzögerung tritt bei der Verwendung von elektronischen Schaltern wie MOSFET und IGBT nicht auf. Diese Ausführungsform hat den Vorteil, dass bei Änderungen der Eingangsspannung im laufenden Betrieb kein manueller Eingriff zur Parametrierung der Anordnung erforderlich.

In einer weiteren bevorzugten Ausführungsform der erfindungsgemäßen Anordnung ist die Konfigurationseinrichtung ausgebildet, die Eingangsspannung bei der Erstinbetriebnahme zu messen und die Konfiguration der Ansteuerungseinrichtung sowie die Verschaltung der Spulen als einen Datensatz auf einem Datenspeicher zu sichern. Die Höhe der Eingangsspannung wird z.B. nur einmalig automatisch bei der Erstinbetriebnahme beim Endkunden durch eine oder mehrere Probeschaltungen ermittelt. Alle notwendigen Konfigurationen für die Spulenverschaltung und die Einstellung der Einschalt- und Halteströme werden persistent auf dem Datenspeicher gespeichert und können nach der Inbetriebnahme nur noch durch manuelles Eingreifen geändert bzw. überschrieben werden.

Es ist ein Vorteil dieser Ausführungsform, dass keine Verzögerung bei der Einschaltung auftritt. Ferner ist diese Ausführungsform unempfindlicher gegenüber (kleineren) Schwankungen der Eingangsspannung.

In einer weiteren bevorzugten Ausführungsform der erfindungsgemäßen Anordnung ist der Datenspeicher ausgebildet, den Datensatz auch im spannungsfreien Zustand sicher speichern zu können. Der Datenspeicher kann z.B. als sog. nichtflüchtiger Speicher ausgebildet sein, d.h., dass die gespeicherten Informationen auf Dauer erhalten bleiben - also auch während der Rechner nicht in Betrieb ist oder nicht mit Strom versorgt wird. Genutzt werden können z.B. solid-state-disks (SSD) oder Flash-Speicher oder nichtflüchtige Arbeitsspeicher (non-volatile random access memory - NVRAM RAM). Auch ein "Electrically Erasable Programmable Read-Only Memory" (EEPROM) kann mit Vorteil eingesetzt werden.

Ausgehend von dem bekannten Schütz stellt sich an die Erfindung die Aufgabe, ein Verfahren anzugeben, mit dem einfach, schnell und sicher eine Umrüstung des Magnetantriebs auf eine andere Eingangsspannung möglich ist.

Die Erfindung löst diese Aufgabe durch ein Verfahren für eine automatische Konfiguration eines Magnetantriebs gemäß Anspruch 8. Bevorzugte Ausführungsformen des erfindungsgemäßen Verfahrens sind in den abhängigen Ansprüchen 9 bis 14 erläutert. Es ergeben sich sinngemäß die gleichen Vorteile wie eingangs für die erfindungsgemäße Anordnung erläutert.

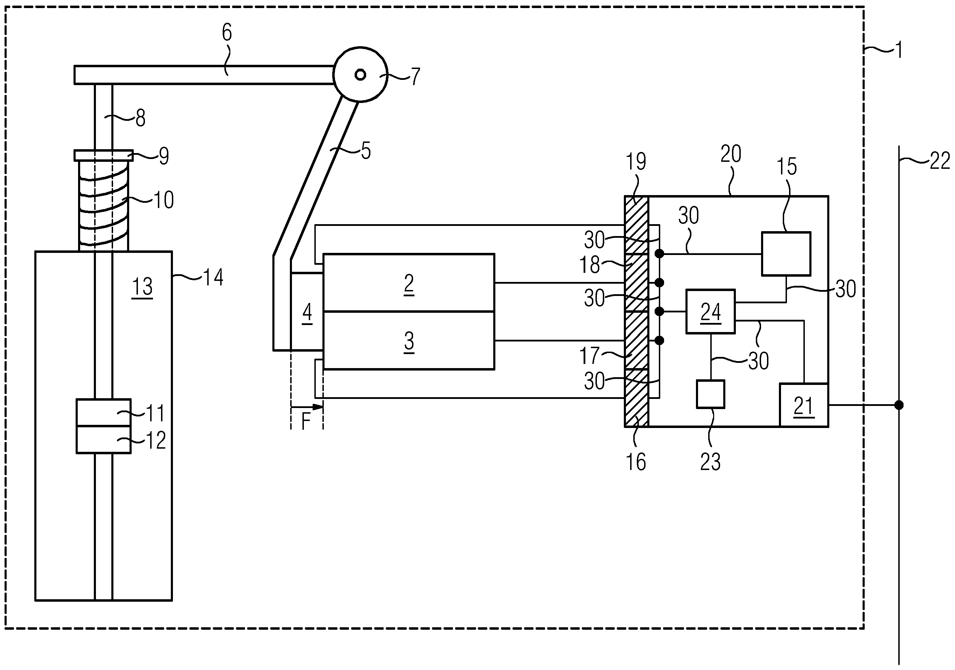

Zur besseren Erläuterung der Erfindung zeigt die Figur in schematischer Darstellung ein Ausführungsbeispiel einer erfindungsgemäßen Anordnung 1.

Die Anordnung 1 weist eine Vakuumschalteinrichtung 8-14 mit einem Gehäuse 14 auf, das fluiddicht und evakuiert 13 ist. Im Inneren des Gehäuses 14 wird ein beweglicher Kontakt 11 an eine Festkontakt 12 angepresst. Dargestellt ist damit der geschlossene Zustand des Schalters mit eingeschaltetem Magnetantrieb 2-4,16-19. Ein Schaltstab 8 ist durch das Gehäuse 14 mit dem beweglichen Kontakt 11 verbunden, wobei z.B. ein nicht dargestellter Faltenbalg die Beweglichkeit sicherstellt. Für ein mechanisches Trennen der Kontakte 11,12 ist eine Federeinrichtung 10 vorgesehen, die an einer Stützplatte 9 abstützt und im dargestellten geschlossenen Zustand vorgespannt ist.

Der Schaltstab 8 ist mit einem Kniehebel 5-7 verbunden, wobei der erste Schenkel 6 und der zweite Schenkel 5 winkelsteif verbunden, aber um das Gelenk 7 drehbar gelagert sind. Der zweite Schenkel 5 ist mit einer Ankerplatte 4 aus Metall, z.B. Eisen, verbunden. Diese Übertragungsmechanik 5-7 übersetzt eine Bewegung des Magnetankers 4 in eine Bewegung des beweglichen Kontakts 11 zum Festkontakt 12 hin.

Der Magnetantrieb 2-4,16-19 weist zwei Spulen 2,3 auf, die mit steuerbaren Schalteinrichtungen 16-19 entweder parallel oder seriell schaltbar sind. Im dargestellten eingeschalteten Zustand wird durch die Spulen 2,3, eine anziehende Kraft F auf den Magnetanker 4 ausgeübt und dieser zu den Spulen 2,3 hinbewegt.

Eine Ansteuerungseinrichtung 15 für den Magnetantrieb 2-4,16-19 kann mittels einer Konfigurationseinrichtung 20 auf eine Eingangsspannung konfiguriert werden, die mittels einer Spannungsmesseinrichtung 21 an einer Netzleitung 22 gemessen wird. Die Ansteuerungseinrichtung 15 regelt Einschalt- und Halteströme für die Spulen 2,3.

Der Magnetantrieb 2-4,16-19 weist steuerbare Schalteinrichtungen 16-19 für die Spulen 2,3 auf. Die Konfigurationseinrichtung 20 verschaltet die Spulen 2,3 in Abhängigkeit von der gemessenen Eingangsspannung mittels der steuerbaren Schalteinrichtungen 16-19 parallel oder seriell.

Die Konfigurationseinrichtung 20 weist intern Datenkommunikationsverbindungen 30 auf, die einen Prozessor 24 mit einem Datenspeicher 23 sowie mit einer Spannungsmesseinrichtung 21 und der Ansteuerungseinrichtung 15 verbinden. Ferner sind die Schalteinrichtungen 16-19 per Datenkommunikationsverbindungen 30 mit dem Prozessor 24 und der Ansteuerungseinrichtung 15 verbunden.

## Patentansprüche

1. Anordnung (1) für eine automatische Konfiguration eines Magnetantriebs (2-4,16-19), aufweisend
eine Vakuumschalteinrichtung (8-14) mit einem beweglichen Kontakt (11) und einem Festkontakt (12), und
einen Magnetantrieb (2-4,16-19) mit zwei Spulen (2,3), die parallel oder seriell schaltbar sind, wobei der Magnetantrieb (2-4,16-19) ausgebildet ist, im eingeschalteten Zustand eine anziehende Kraft (F) auf einen Magnetanker (4) auszuüben und diesen zu bewegen, und
eine Übertragungsmechanik (5-7), die ausgebildet ist, eine Bewegung des Magnetankers (4) in eine Bewegung des beweglichen Kontakts (11) zum Festkontakt (12) hin zu übersetzen, und
eine Ansteuerungseinrichtung (15) für den Magnetantrieb (2-4,16-19), die auf eine Eingangsspannung konfigurierbar ist,
**dadurch gekennzeichnet, dass**
der Magnetantrieb (2-4,16-19) steuerbare Schalteinrichtungen (16-19) für die Spulen (2,3) aufweist, und dass
eine Konfigurationseinrichtung (20) ausgebildet ist, die Eingangsspannung zu messen und die Ansteuerungseinrichtung (15) auf die gemessene Eingangsspannung zu konfigurieren, und die Spulen (2,3) in Abhängigkeit von der gemessenen Eingangsspannung mittels der steuerbaren Schalteinrichtungen (16-19) parallel oder seriell zu verschalten.

2. Anordnung nach Anspruch 1,
**dadurch gekennzeichnet, dass**
die Konfigurationseinrichtung (20) ausgebildet ist, die Spulen (2,3) für eine gemessene Eingangsspannung von 90 V bis 150 V parallel zu schalten und für eine gemessene Eingangsspannung von 180 V bis 250 V seriell zu schalten.

3. Anordnung nach Anspruch 1 oder 2,
**dadurch gekennzeichnet, dass**
die Konfigurationseinrichtung (20) ausgebildet ist, die Ansteuerungseinrichtung (15) auf die gemessene Eingangsspannung zu konfigurieren, indem Einschalt- und Halteströme festgelegt werden.

4. Anordnung nach einem der vorhergehenden Ansprüche,
**dadurch gekennzeichnet, dass**
die steuerbaren Schalteinrichtungen (16-19) mindestens eine der folgenden Schalteinrichtungen aufweisen: MOSFET, IGBT, Relais.

5. Anordnung nach einem der vorhergehenden Ansprüche,
**dadurch gekennzeichnet, dass**
die Konfigurationseinrichtung (20) ausgebildet ist, vor jedem Schaltvorgang die Eingangsspannung zu messen und die Ansteuerungseinrichtung (15) zu konfigurieren und die Spulen (2,3) zu verschalten.

6. Anordnung nach einem der vorhergehenden Ansprüche,
**dadurch gekennzeichnet, dass**
die Konfigurationseinrichtung (20) ausgebildet ist, die Eingangsspannung bei der Erstinbetriebnahme zu messen und die Konfiguration der Ansteuerungseinrichtung (15) sowie die Verschaltung der Spulen (2,3) als einen Datensatz auf einem Datenspeicher (23) zu sichern.

7. Anordnung nach Anspruch 6,
**dadurch gekennzeichnet, dass**
der Datenspeicher (23) ausgebildet ist, den Datensatz auch im spannungsfreien Zustand sicher speichern zu können.

8. Verfahren für eine automatische Konfiguration eines Magnetantriebs (2-4,16-19), mit den Schritten:
Bereitstellen einer Vakuumschalteinrichtung (8-14) mit einem beweglichen Kontakt und einem Festkontakt, und
Bereitstellen eines Magnetantriebs (2-4,16-19) mit zwei Spulen (2,3), die parallel oder seriell schaltbar sind, wobei der Magnetantrieb (2-4,16-19) im eingeschalteten Zustand eine anziehende Kraft (F) auf einen Magnetanker (4) ausübt und diesen bewegt, und
Übertragen einer Bewegung des Magnetankers (4) in eine Bewegung des beweglichen Kontakts (11) zum Festkontakt (12) hin mittels einer Übertragungsmechanik (5-7), und
Messen einer Eingangsspannung mittels einer Messeinrichtung (21),
**gekennzeichnet durch** die Schritte:
Konfigurieren einer Ansteuerungseinrichtung (15) für den Magnetantrieb (2-4,16-19) auf die Eingangsspannung mittels einer Konfigurationseinrichtung (20), und
paralleles oder serielles Verschalten der Spulen (2,3) in Abhängigkeit von der gemessenen Eingangsspannung mittels steuerbarer Schalteinrichtungen (16-19) des Magnetantriebs (2-4,16-19) mittels der Konfigurationseinrichtung (20).

9. Verfahren nach Anspruch 8,
**dadurch gekennzeichnet, dass**
die Spulen (2,3) für eine gemessene Eingangsspannung von 90 V bis 150 V parallelgeschaltet und für eine gemessene Eingangsspannung von 180 V bis 250 V seriell geschaltet werden.

10. Verfahren nach Anspruch 8 oder 9,
**dadurch gekennzeichnet, dass**
die Ansteuerungseinrichtung (15) auf die gemessene Eingangsspannung konfiguriert wird, indem Einschalt- und Halteströme festgelegt werden.

11. Verfahren nach einem der Ansprüche 8 bis 10,
**dadurch gekennzeichnet, dass**
für die steuerbaren Schalteinrichtungen (16-19) mindestens eine der folgenden Schalteinrichtungen verwendet wird: MOSFET, IGBT, Relais.

12. Verfahren nach einem der Ansprüche 8 bis 11,
**dadurch gekennzeichnet, dass**
vor jedem Schaltvorgang die Eingangsspannung gemessen und die Ansteuerungseinrichtung (15) konfiguriert und die Spulen (2,3) verschaltet werden.

13. Verfahren nach einem der Ansprüche 8 bis 12,
**dadurch gekennzeichnet, dass**
die Eingangsspannung bei der Erstinbetriebnahme gemessen und die Konfiguration der Ansteuerungseinrichtung (15) sowie die Verschaltung der Spulen (2,3) als ein Datensatz auf einem Datenspeicher (23) gesichert werden.

14. Verfahren nach Anspruch 13,
**dadurch gekennzeichnet, dass**
ein Datenspeicher (23) verwendet wird, der den Datensatz auch im spannungsfreien Zustand sicher speichert.

## Claims

1. Arrangement (1) for automatically configuring a magnetic drive (2-4, 16-19), said arrangement comprising:
a vacuum switching device (8-14) having a movable contact (11) and a fixed contact (12), and
a magnetic drive (2-4, 16-19) having two coils (2, 3) which can be connected in parallel or in series, wherein the magnetic drive (2-4, 16-19) is designed, in the switched-on state, to exert an attractive force (F) on a magnet armature (4) and to move said magnet armature, and
a transfer mechanism (5-7) which is designed to translate a movement of the magnet armature (4) into a movement of the movable contact (11) toward the fixed contact (12), and
an actuating device (15) for the magnetic drive (2-4, 16-19), which actuating device can be configured for an input voltage,
**characterized in that**
the magnetic drive (2-4, 16-19) has controllable switching devices (16-19) for the coils (2, 3), and **in that**
a configuration device (20) is designed to measure the input voltage and to configure the actuating device (15) for the measured input voltage, and to interconnect the coils (2, 3) in parallel or in series depending on the measured input voltage by means of the controllable switching devices (16-19).

2. Arrangement according to Claim 1,
**characterized in that**
the configuration device (20) is designed to connect the coils (2, 3) in parallel for a measured input voltage of 90 V to 150 V and to connect them in series for a measured input voltage of 180 V to 250 V.

3. Arrangement according to Claim 1 or 2,
**characterized in that**
the configuration device (20) is designed to configure the actuating device (15) for the measured input voltage by virtue of switch-on and holding currents being set.

4. Arrangement according to any one of the preceding claims, **characterized in that**
the controllable switching devices (16-19) comprise at least one of the following switching devices: MOSFET, IGBT, relay.

5. Arrangement according to any one of the preceding claims, **characterized in that**
the configuration device (20) is designed to measure the input voltage and to configure the actuating device (15) and to interconnect the coils (2, 3) before each switching process.

6. Arrangement according to any one of the preceding claims, **characterized in that**
the configuration device (20) is designed to measure the input voltage upon initial start-up and to save the configuration of the actuating device (15) and the interconnection of the coils (2, 3) as a data set in a data memory (23).

7. Arrangement according to Claim 6,
**characterized in that**
the data memory (23) is designed to be able to reliably store the data set in the zero-voltage state as well.

8. Method for automatically configuring a magnetic drive (2-4, 16-19), comprising the following steps:
providing a vacuum switching device (8-14) having a movable contact and a fixed contact, and
providing a magnetic drive (2-4, 16-19) having two coils (2, 3) which can be connected in parallel or in series, wherein the magnetic drive (2-4, 16-19), in the switched-on state, exerts an attractive force (F) on a magnet armature (4) and moves said magnet armature, and
transferring a movement of the magnet armature (4) into a movement of the movable contact (11) toward the fixed contact (12) by means of a transfer mechanism (5-7), and
measuring an input voltage by means of a measuring device (21),
**characterized by** the following steps:
configuring an actuating device (15) for the magnetic drive (2-4, 16-19) for the input voltage by means of a configuration device (20), and
interconnecting the coils (2, 3) in parallel or in series depending on the measured input voltage by means of controllable switching devices (16-19) of the magnetic drive (2-4, 16-19) by means of the configuration device (20).

9. Method according to Claim 8,
**characterized in that**
the coils (2, 3) are connected in parallel for a measured input voltage of 90 V to 150 V and are connected in series for a measured input voltage of 180 V to 250 V.

10. Method according to Claim 8 or 9,
**characterized in that**
the actuating device (15) is configured for the measured input voltage by virtue of switch-on and holding currents being set.

11. Method according to any one of Claims 8 to 10,
**characterized in that**
at least one of the following switching devices is used for the controllable switching devices (16-19): MOSFET, IGBT, relay.

12. Method according to any one of Claims 8 to 11,
**characterized in that**
the input voltage is measured and the actuating device (15) is configured and the coils (2, 3) are interconnected before each switching process.

13. Method according to any one of Claims 8 to 12,
**characterized in that**
the input voltage is measured upon initial start-up and the configuration of the actuating device (15) and the interconnection of the coils (2, 3) are saved as a data set in a data memory (23).

14. Method according to Claim 13,
**characterized in that**
a data memory (23) is used to reliably store the data set in the zero-voltage state as well.

## Revendications

1. Agencement (1) de configuration automatique d'un entraînement (2-4, 16-19) magnétique, comportant un dispositif (8-14) de coupure à vide ayant un contact (11) mobile et un contact (12) fixe, et
un entraînement (2-4, 16-19) magnétique ayant deux bobines (2, 3), qui peuvent être montées en parallèle ou en série, dans lequel l'entraînement (2-4, 16-19) magnétique est constitué pour, dans un état en circuit, appliquer une force (F) d'attraction à une armature (4) d'aimant et la déplacer, et
une mécanique (5-7) de transmission, qui est constituée pour transformer un mouvement de l'armature (4) d'aimant en un mouvement du contact (11) mobile par rapport au contact (12) fixe, et
un dispositif (15) de commande de l'entraînement (2-4, 16-19) magnétique, qui peut être configuré sur une tension d'entrée,
**caractérisé en ce que**
l'entraînement (2-4, 16-19) magnétique a des dispositifs (16-19) de coupure pouvant être commandés pour les bobines (2, 3), et **en ce qu'**un dispositif (20) de configuration est constitué pour mesurer la tension d'entrée et pour configurer le dispositif (15) de commande sur la tension d'entrée mesurée et pour, en fonction de la tension d'entrée mesurée, monter les bobines (2, 3) en parallèle ou en série au moyen des dispositifs (16-19) de coupure pouvant être commandés.

2. Agencement suivant la revendication 1,
**caractérisé en ce que**
le dispositif (20) de configuration est constitué pour monter les bobines (2, 3) en parallèle pour une tension d'entrée mesurée de 90 V à 150 V et les monter en série pour une tension d'entrée de 180 V à 250 V.

3. Agencement suivant la revendication 1 ou 2,
**caractérisé en ce que**
le dispositif (20) de configuration est constitué pour configurer le dispositif (15) de commande sur la tension d'entrée mesurée en déterminant des courants de mise en circuit et de maintien.

4. Agencement suivant l'une des revendications précédentes, **caractérisé en ce que**
les dispositifs (16-19) de coupure pouvant être commandés ont au moins l'un des dispositifs de coupure suivants : MOSFET, IGBT, relais.

5. Agencement suivant l'une des revendications précédentes, **caractérisé en ce que**
le dispositif (20) de configuration est constitué pour mesurer la tension d'entrée avant chaque opération de coupure et pour configurer le dispositif (15) de commande et pour monter les bobines (2, 3).

6. Agencement suivant l'une des revendications précédentes, **caractérisé en ce que**
le dispositif (20) de configuration est constitué pour mesurer la tension d'entrée, lors de la première mise en fonctionnement, et pour sécuriser la configuration du dispositif (15) de commande ainsi que le montage des bobines (2, 3) sous la forme d'un ensemble de données dans une mémoire (23) de données.

7. Agencement suivant la revendication 6,
**caractérisé en ce que**
la mémoire (23) de données est constituée pour pouvoir mettre en mémoire, de manière sécurisée, l'ensemble de données, même à l'état sans tension.

8. Procédé de configuration automatique d'un entraînement (2-4, 16-19) magnétique, comprenant les stades :
on se procure un dispositif (8-14) de coupure à vide comprenant un contact mobile et un contact fixe, et
on se procure un entraînement (2-4, 16-19) magnétique ayant deux bobines (2, 3), qui peuvent être montées en parallèle ou en série, dans lequel l'entraînement (2-4, 16-19) magnétique applique, dans l'état de mise en circuit, une force (F) d'attraction sur une armature (4) d'aimant et la déplace, et
on transforme un déplacement de l'armature (4) magnétique en un déplacement du contact (11) mobile par rapport au contact (12) fixe au moyen d'une mécanique (5-7) de transformation, et
on mesure une tension d'entrée au moyen d'un dispositif (21) de mesure,
**caractérisé par** les stades :
configuration d'un dispositif (15) de commande de l'entraînement (2-4, 16-19) magnétique sur la tension d'entrée au moyen d'un dispositif (20) de configuration, et
montage, au moyen du dispositif (20) de configuration, des bobines (2, 3) en parallèle ou en série en fonction de la tension d'entrée mesurée au moyen de dispositifs (16-19) de coupure pouvant être commandés de l'entraînement (2-4, 16-19) magnétique.

9. Procédé suivant la revendication 8,
**caractérisé en ce que**
l'on monte les bobines (2, 3) pour une tension d'entrée mesurée de 90 V à 150 V en parallèle et en série pour une tension d'entrée mesurée de 180 V à 250 V.

10. Procédé suivant la revendication 8 ou 9,
**caractérisé en ce que**
l'on configure le dispositif (15) de commande sur la tension d'entrée mesurée en déterminant des courants de mise en circuit et de maintien.

11. Procédé suivant l'une des revendications 8 à 10,
**caractérisé en ce que**
l'on utilise, pour les dispositifs (16-19) de coupure pouvant être commandés au moins l'un des dispositifs de coupure suivants : MOSFET, IGBT, relais.

12. Procédé suivant l'une des revendications 8 à 11,
**caractérisé en ce que**,
avant chaque opération de coupure, on mesure la tension d'entrée et on configure le dispositif (15) de commande et on monte les bobines (2, 3).

13. Procédé suivant l'une des revendications 8 à 12,
**caractérisé en ce que**
l'on mesure la tension d'entrée lors de la première mise en service et on sécurise la configuration du dispositif (15) de commande ainsi que le montage des bobines (2, 3) dans une mémoire (23) de données sous la forme d'un ensemble de données.

14. Procédé suivant la revendication 13,
**caractérisé en ce que**
l'on utilise une mémoire (23) de données, qui met en mémoire, de manière sécurisée, l'ensemble de données même à l'état sans tension.
